# EUROPEAN PATENT SPECIFICATION

(11) **EP 0 858 077 B1**
(45) Date of publication and mention of the grant of the patent: **05.07.2006**
(21) Application number: 98300490.4
(22) Date of filing: 23.01.1998
(51) Int. Cl.: G11C 15/04

(54) **Content addressable memory**
Inhaltaddressierter Speicher
Mémoire associative

(30) Priority: 06.02.1997 US 37834 P; 04.09.1997 US 923823
(43) Date of publication of application: 12.08.1998
(73) Proprietor: Nortel Networks Limited, St.Laurent, Quebec H4S 2A9 (CA)
(72) Inventor: Schultz, Kenneth James, Kanata, Ontario, K2K 2B6 (CA); Gibson, Garnet Frederick Randall, Nepean, Ontario, K2G 5V5 (CA); Shafai, Farhad, Nepean, Ontario, K2J 4K8 (CA); Bluschke, Armin George, Nepean, Ontario, K2H 5N8 (CA)
(74) Representative: Ertl, Nicholas Justin

(56) References cited:
- EP-A- 0 624 844
- EP-A- 0 650 167
- WO-A-96/33499
- US-A- 4 723 224
- US-A- 4 813 002
- US-A- 5 072 422
- US-A- 5 530 665
- PATENT ABSTRACTS OF JAPAN vol. 018, no. 216 (P-1728), 18 April 1994 (1994-04-18) & JP 06 012883 A (MATSUSHITA ELECTRIC IND CO LTD), 21 January 1994 (1994-01-21)
- PATENT ABSTRACTS OF JAPAN vol. 018, no. 587 (P-1824), 10 November 1994 (1994-11-10) & JP 06 215583 A (OKI ELECTRIC IND CO LTD), 5 August 1994 (1994-08-05)
- ZUKOWSKI C A ET AL: "USE OF SELECTIVE PRECHARGE FOR LOW-POWER CONTENT-ADDRESSABLE MEMORIES" ISCAS '97. PROCEEDINGS OF THE 1997 IEEE INTERNATIONAL SYMPOSIUM ON CIRCUITS AND SYSTEMS. CIRCUITS AND SYSTEMS IN THE INFORMATION AGE, HONG KONG, JUNE 9 - 12, 1997, vol. 3, 9 June 1997 (1997-06-09), pages 1788-1791, XP000802922 INSTITUTE OF ELECTRICAL AND ELECTRONICS ENGINEERS ISBN: 0-7803-3584-8

## Description

### Technical Field

The present invention relates to content addressable memory (CAM).

### Background Information

CAMs are memories in which data is selected based on its contents, rather than its physical location. This function is useful for many applications, especially when performing a look-up for the purposes of mapping from a long identification word to a shorter word. This operation is required in many telecom functions, including Asynchronous Transfer Mode (ATM) address translation.

United States Patent No. 5,289,403 entitled "Self-Timed Content Addressable Memory Access Mechanism with Built-In Margin Test Feature" granted to J.D. Yetter on February 22, 1994 describes a means of providing self-timing to a NOR-match line CAM, using a dummy column and dummy row. The bit at the intersection of the dummy column and dummy row always misses, while all other cells in that row always match, and this generates the slowest possible mismatch condition on the dummy match line. This signal is then used to generate a clock for timing of subsequent events, and for qualifying all other match lines.

United States Patent No. 5,453,948 entitled "Associative Memory" granted to M. Yoneda on September 26, 1995 describes a low-power implementation of a match line, in which the match line is realized as a series chain, instead of a NOR.

United States Patent No. 5,455,784 entitled "Associative Memory Device with Small Memory Cells Selectively Storing Data Bits and Don't Care Bits" granted to H. Yamada on October 3, 1995 describes a CAM with individual storage cells comprised of a series combination of two EEPROM devices. The series connection of these cells (one per bit) to form a word of CAM results in a series match line chain. Shifted transistor threshold voltages, resulting from programming, cause the EEPROM devices to act as either enhancement- or depletion-mode transistors, and hence "don't cares" may be stored by making both devices depletion-mode.

United States Patent No. 5,469,378 entitled "Content Addressable Memory Having Match Line Transistors Connected in Series and Coupled to Current Sensing Circuit" granted to R. Albon et al on November 21, 1995 describes a series match line chain.

Most previous CAMs employ a dynamic wired-NOR match line pull-down, which provides high speed. However, the prior art circuit construction causes match lines associated with mismatched words to experience transitions, while no transitions occur on match lines associated with matched words. Since the number of matches is much smaller than the number of mismatches, the number of transitions, and hence the power dissipation, is excessive for a wired-NOR match line CAM.

WO 96 33499 A discloses a CAM as indicated in the preamble of claim 1. It provides several logical memory arrays which are subdivided into several blocks. This arrangement minimises CAM parasite capacities but provides similar power dissipation to known CAM arrangements.

JP 06 012883 discloses an associative storage device in which power consumption is reduced by serially connecting the core cells of the match line chain segments.

US-A-5530665 discloses associative memories in which a pair of attribute and data is stored in each word memory. Retrieval is performed using reference data applied from an exterior and the pair of attribute and data stored in each word memory of associative memories. Upon receipt of a match of the attribute, a signal representing a match or mismatch of both attribute and data except the attribute is supplied to a data line. At the time of subsequent retrieval, upon receipt of a match of the attribute, data appearing on the data line is taken in.

EP-A-0650167 and US-A-4723224 disclose apparatus and methods for field masking in CAMs.

JP 06 215583 discloses an associative memory in which power consumption on a match line is reduced. Power consumption on match lines is removed after a level change on a dummy match line.

EP-A-0624844 discloses an integrated cache architecture that has low power consumption, high noise immunity, and full support of an integrated validity/LRU cache write mode.

US-A-5072422 discloses a CAM system that stores large amounts of data for quick access by keyword value combinations. The system comprises a controller and a plurality of CAM chips. Each chip comprises a plurality of word cells with logic to enable independent, parallel operation of each word cell, storage of a record of closely related data in more than one word cell, and accessing an entire record when data in one word cell is matched to the keyword value.

### Summary Of The Invention

The present invention intends to implement CAMs of sufficient capacities for ATM address translation table applications, for example. The inadequacy of techniques known as prior art is due to both architectural and circuit limitations. Two of the design problems that are addressed by the present invention are (i) the implementation of two-dimensional decoding, necessary to achieve a reasonable array aspect ratio for a large memory; and (ii) achieving low power dissipation, despite the simultaneous searching of the entire contents of the large CAM.

To achieve implementation of two-dimensional decoding, there must be multiple words in a single physical row. This can be achieved by either (a) sharing match lines between multiple words, or (b) having multiple match lines per physical row. In this invention, the second approach is chosen.

According to the most general aspect of the present invention, there is provided a content addressable memory, hereinafter referred to as a CAM, comprising: w words of matching means, each word comprising b core cells arranged into i match line chain segments, each match line chain segment comprising b/i core cells, each core cell comprising means for storing data, w, i, b and b/i being integers, i and b/i being greater than or equal to two; AND or NAND logic means for logically coupling the match line chain segments in a respective word; and encoding means for providing search results based on the outputs from the logic means, characterised in that: the core cells of each match line chain segment are chained in series by a match line; and the order of bits in a word is deterministically scrambled among different match line chain segments making up said word.

For example, the logic means comprises NAND circuit means. In a case of the NAND circuit being dynamic NAND circuit, power dissipation decreases. The CAM may further comprise means for sensing the transitions of data signals on the chains. In the CAM, the cell arrays are segment pairs which are oriented in mirror images, such that their outputs face each other, facilitating the logic combination of the two partial match results from the two cell arrays, by the logic means.

The CAM may employ a dummy word, but it does not employ a dummy column. As well, the dummy words model a match, rather than a mismatch. The words in the CAM are divided into a plurality of segments, with a match line chain per segment. The CAM uses purely voltage sensing means.

### Brief Description Of The Drawings

The present invention will be further understood from the following description with reference to the accompanying drawings, in which:
Figure 1 illustrates a prior art CAM;
Figure 2 illustrates a CAM according to an embodiment of the present invention;
Figure 3 illustrates a logical equivalence of a NOR and NOT-AND gates;
Figure 4 illustrates a logical segmentation of the NOT-AND gates;
Figure 5A illustrates a match line circuit composed of two segments;
Figure 5B captures conceptually the two segment circuit shown in Figure 5A;
Figure 6A illustrates a single word of storage with its match line;
Figure 6B illustrates four words sharing an encoder;
Figure 7A illustrates a single physical row with two encoders;
Figure 7B illustrates an array with a plurality of the rows illustrated in Figure 7A;
Figure 8A illustrates multiple words of four segments each;
Figure 8B illustrates multiple words of eight segments each;
Figure 9 is a transistor-level schematic diagram of a memory core cell;
Figure 10 is a view of memory core cell upper metal layers;
Figure 11 illustrates a first example of a modified core cell;
Figure 12 illustrates a second example of a modified core cell;
Figure 13 illustrates a third example of a modified core cell;
Figure 14 illustrates a dummy chain used to detect the completion of precharge;
Figure 15 illustrates a simple implementation of a precharge sense circuit;
Figure 16A illustrates a pull-down chain circuit with in-cycle precharge;
Figure 16B illustrates signal timing of the precharge;
Figure 17A illustrates a pull-up chain circuit with in-cycle precharge;
Figure 17B illustrates signal timing of the precharge;
Figure 18A illustrates a pull-down chain circuit with quiescent precharge;
Figure 18B illustrates signal timing of the precharge;
Figure 19A illustrates a pull-up chain circuit with quiescent precharge;
Figure 19B illustrates signal timing of the precharge;
Figure 20A illustrates a pull-down chain circuit with quiescent precharge from both ends of the chain;
Figure 20B illustrates signal timing of the precharge;
Figure 21A illustrates a pull-up chain circuit with quiescent precharge from both ends of the chain;
Figure 21B illustrates signal timing of the precharge;
Figure 22A illustrates a pull-down chain circuit with quiescent precharge and a single clock-controlled quiescent-off device;
Figure 22B illustrates signal timing of the precharge;
Figure 23A illustrates a pull-up chain circuit with quiescent precharge and a single clock-controlled quiescent-off device;
Figure 23B illustrates signal timing of the precharge;
Figure 24A illustrates a pull-down chain circuit with quiescent precharge and a single data-controlled quiescent-off device;
Figure 24B illustrates signal timing of the precharge;
Figure 25A illustrates a pull-up chain circuit with quiescent precharge and a single data-controlled quiescent-off device;
Figure 25B illustrates signal timing of the precharge;
Figure 26A illustrates a pull-down chain circuit with quiescent precharge and intentional charge sharing;
Figure 26B illustrates signal timing of the precharge;
Figure 27A illustrates a pull-up chain circuit with quiescent precharge and intentional charge sharing;
Figure 27B illustrates signal timing of the precharge; and
Figure 28 illustrates an architecture in which columns are organized in a word-sliced fashion.

### Detailed Description

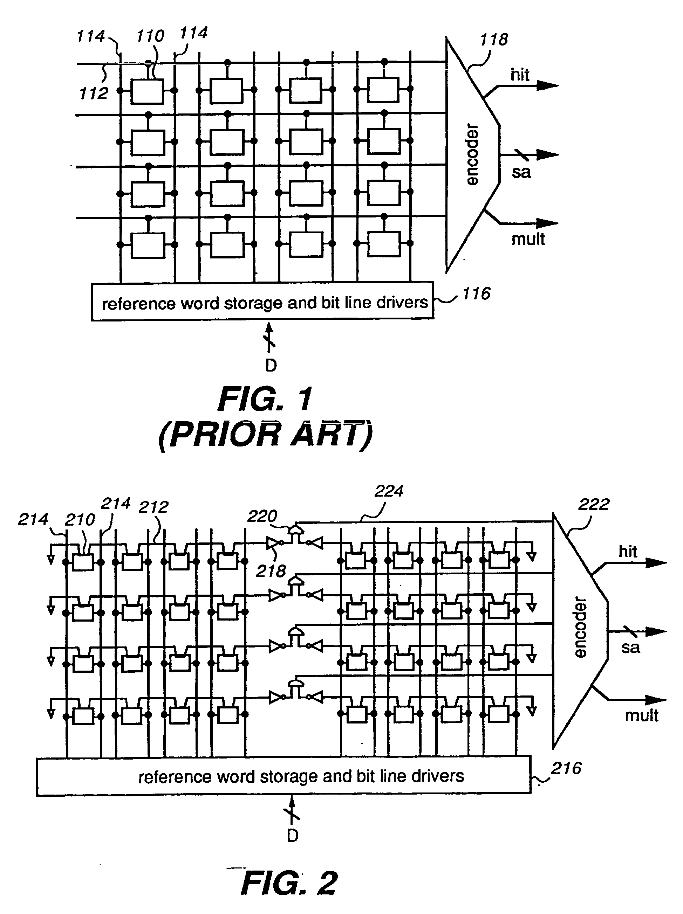

The majority of prior art CAMs employ wired-NOR match lines, as shown in Figure 1. Referring to Figure 1, a single chip CAM of w (=4) words x b (=4) bits is implemented as a CAM with w rows and b columns. The memory array includes w x b (=16) memory core cells 110, each being at the intersection of a match line 112 and a pair of bit lines 114. A pair of bit lines 114 carry differential data representing a single bit, rather than two bits of data. Each core cell 110 acts to store a single bit of data and is capable of performing a single-bit comparison (logical exclusive NOR (XNOR)) operation, in addition to its bit storage capability. In Figure 1, the cells 110 belonging to a given word are connected to the match line 112 of that word in a logical NOR fashion.

The bit lines 114 for differential data are connected to reference word storage and bit line drivers 116 which receive input data D for loading the contents of the CAM and for the search reference word. Data stored in the array's core cells 110 are searched by applying a reference word on the bit lines 114.

When differential data is asserted on a pair of bit lines 114 in a search operation, the core cell 110 compares its stored data bit with the differential data (also known as reference data, or a single bit of the comparand). When the stored data is not equal to the reference data, the core cell 110 pulls the match line 112 (which is precharged to a logical high state) down to a low state. When the stored data is equal to the reference data, the cell 110 has no effect on the match line 112 to which it is connected. Because all b core cells 110 in a given word are connected to the match line 112 in the same way, the match line 112 will be pulled low if any bit in its word is unequal to (or mismatches) the corresponding reference bit. The match line 112 remains in a logical high state only if all bits in its word are equal to the reference data.

The CAM includes an encoder 118 which produces three outputs representing the result of the search operation. A hit signal hit will be asserted to a logical high state, if any of the w words is storing data which has matched the reference data. The binary address of this matching word is encoded and an address signal sa is provided. In the event that a plurality of words have matched the reference data, a multi-match signal mult is asserted to a logical high state. In this event, the address sa output of the encoder 118 may produce (a) an invalid result, (b) an address representing the location of a single one of the multiple matches, or (c) a sequence of outputs, representing the locations of each of the matched words. Note that some applications may not require the "mult" result.

An alternative CAM of a large-capacity having time-shared comparators and multiple match lines running over each core cell is disclosed in United States Patent Application No. 08/748,928 entitled "Large-Capacity Content Addressable Memory", filed on November 14, 1996 by K.J. Schultz et al, which is incorporated herein by reference. The CAM employs a dynamic wired-NOR match line pull-down and includes single-bit comparators which are not located in the core cells, but are instead time-shared among multiple words. The circuit construction causes match lines connected to mismatched words to experience transitions, while matched words cause no transitions.

Because it is expected that only one, or at the most a very few match will occur, the number of transitions and the resulting power dissipation are excessive for a NOR match line.

Figure 2 shows a CAM according to an embodiment of the present invention. Referring to Figure 2, there are w (=4) words shown, each occupying a row, and each having b (=8) bits and b (=8) core cells 210. The words are divided into two halves, and the results of the match on each half word are combined. Each of the two halves is provided with an array of 4 rows x 4 columns. The array includes 16 core cells 210, each being at the intersection of a match line 212 and a pair of bit lines 214 which carry differential data representing a single bit. The bit lines 214 for differential data are connected to reference word storage and bit line drivers 216 which receive input data D for loading the contents of the CAM and for the search reference word. Data stored in the array's core cells 210 are searched by applying a reference word on the bit lines 214.

Each core cell 210 acts to store a single bit of data and is capable of performing a single-bit comparison (logical exclusive NOR (XNOR)) operation, in addition to its bit storage capability. In Figure 2, the cells 210 belonging to a given word are connected to the match line 212 of that word in a logical NAND fashion. The core cells 210 of each word are chained in the respective match line 212. One end of each chain is connected to an inverter 218. The other end of the chain is connected to a terminal of logic 0. The outputs of the inverters 218 are connected to an AND gate 220, the output of which is referred to as a "word match line" 224, and which is connected to an encoder 222.

In Figure 2, the connection (in each half word) is in a logical NAND. The match line 212 will only have a downward transition, if all of the bits in the half word are equal to the reference data. Hence, the path to ground for the match line 212 is serial (a "match line chain") rather than parallel, and the path is made conductive (i.e., the circuit is closed) in the event of a match, rather than a mismatch.

The advantage of this technique is due to the much smaller number of match lines 212 subject to a transition in each search operation: one per match in the embodiment shown in Figure 2, compared to one per mismatch in the prior art circuit shown in Figure 1. This reduces power dissipation considerably, allowing the realization of larger storage capacities. The division of the word into halves decreases the length of the NAND chain, thus increasing speed.

The embodiment of a CAM shown in Figure 2 also includes means of placing multiple words in a physical row, by employing an upper metal layer above the core cell for multiple word match lines 224. This further increases the storage capacity that can be realized.

The CAM produces three output signals hit, sa and mult that represent the result of the search operation, and these may all be generated by the encoder 222. The hit signal hit is asserted to a logical high state if any of the w words is storing data which has matched the reference data. The binary address of this matching word is encoded and the address signal sa is provided. In the event that a plurality of words have matched the reference data, a multi-match signal mult is asserted to a logical high state. In this event, the address sa output of the encoder 222 may produce (a) an invalid result, (b) an address representing the location of a single one of the multiple matches, or (c) a sequence of outputs, representing the locations of each of the matched words.

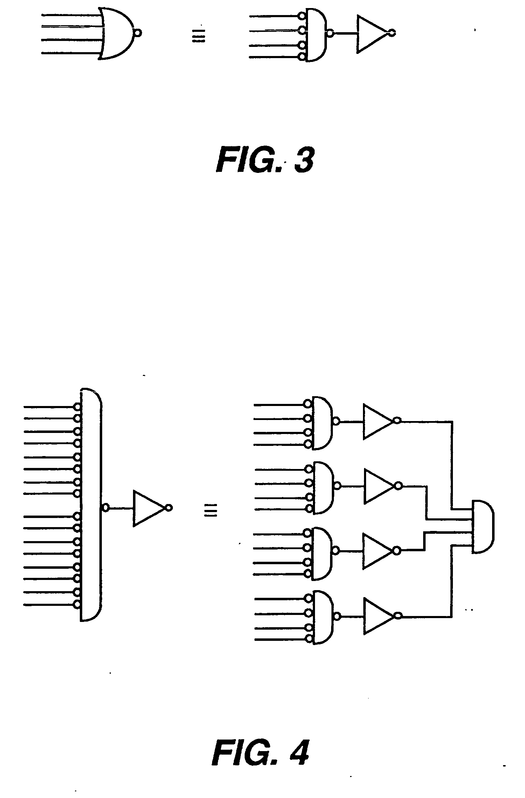

The CAM shown in Figure 2 employs a lower-power circuit of equivalent function to the NOR match line. A logical equivalent of a NOR is a NOT-AND, as shown in Figure 3. Thus, instead of checking whether any bit mismatches, and producing a logical ml = match, it may be checked whether all bits match (which, if true, will result in a pull-down), yielding the logical mln = match. This choice of Boolean implementation results in far fewer transitions (because transitions only occur in the case of matches), and therefore, lower power dissipation. Unfortunately, it is obvious that a dynamic NAND will be slower than a dynamic NOR. This is especially true for the wide words (b >16). On the one hand, delay caused by such a long pull-down chain becomes tolerable in advanced CMOS technologies, especially in relation to a "slow" (<100 MHz) application. On the other hand, it would be beneficial to take some steps to reduce the delay. This is easily done by dividing the word into a number i ³ 2 segments, with one series chain per segment, combining the results as shown in Figure 4. This satisfies the concurrent design goals of high speed and wide words.

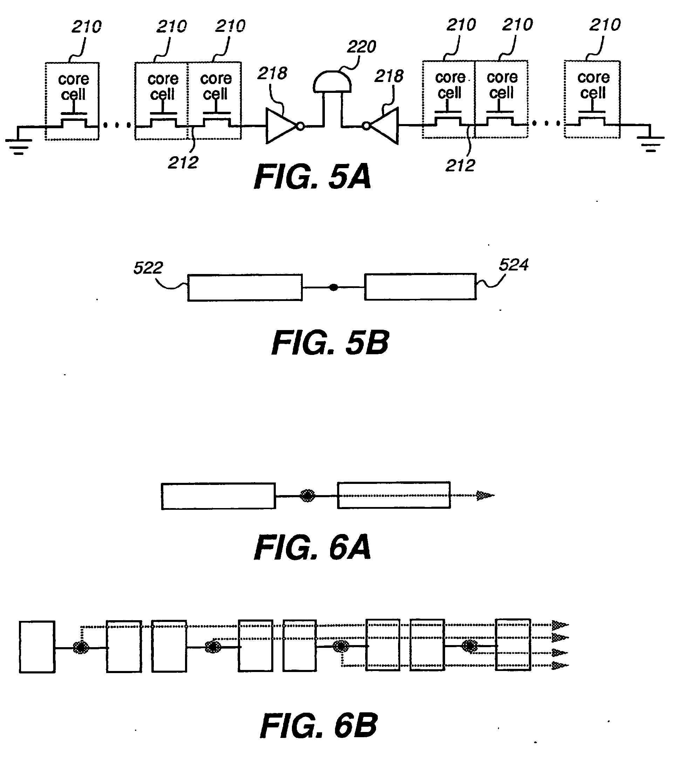

It is clear that, when each first-stage NAND is implemented as a dynamic gate, it results in more transitions and higher power due to matches of partial words. Hence, there results a continuous power-speed trade-off: the more segments into which the word is divided, the higher the speed and power, with the logical extreme in both speed and power being the NOR. At the other extreme of low speed and low power is the single NAND chain, which is equally undesirable. Because the simplest segmentation to implement is a division into i = 2 chains, this will serve as the example embodiments shown Figures 5A, 6A and 7A.

Figure 5A shows a match line circuit composed of two segments (two chains) which are used in the CAM shown in Figure 2. Figure 5B shows conceptually first and second segments (chains) 522 and 524. Referring to Figure 5A, N-channel FETs of the match line chains are shown explicitly with core cells. Each of the match line chains is connected to the inverter 218 and each output of the two inverters 218 is connected to the AND gate 220. With the word divided in two, the second chain 524 is oriented as the mirror image of the first chain 522, and they are brought together, such that their outputs face each other. In Figure 5A, the chain is physically implemented as a pull-down chain, with a GND (or VSS) connection used at one end opposite the output of the chain. Alternatively, the chain may physically be implemented as a pull-up chain, with a power (or VDD) connection used at one end opposite the output of the chain and with the inverters logically removed.

The word match line must be routed to an encoder, where the actual physical address information is derived from the match information, as described above, and shown in Figure 2. This routing is most easily done above the core cells, in the highest level of metal available. This is done in Figure 6A for a single word, assuming the encoder (not shown) is to the right. One may, by extension, run multiple match lines over each core cell, and place multiple columns of words adjacent to the same encoder, as shown in Figure 6B. A capacity that is a multiple of four words may be achieved by stacking a plurality of these units in the vertical dimension.

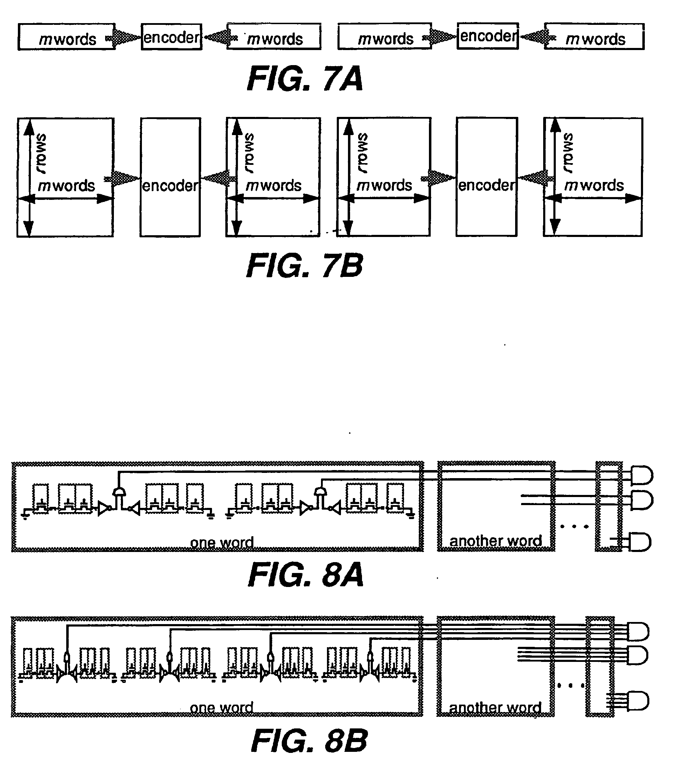

If the number of word match lines over each core cell (actually, the number of word match lines over the core cells closest to the encoder) is m, there will be m words adjacent to each other, with no intervening encoder. As shown in Figures 7A and 7B, one is not limited to a single encoder. There are 2*m words associated with each encoder, per row.

If the number of encoders is e, there will be 2*m*e words per row. If the number of rows is r, the array will have a capacity of 2*m*e*r words. The outputs of the e encoders may be combined at the physical bottom or top of the array shown in Figure 7B.

If, instead of dividing a word into exactly i = 2 segments, it is divided into i > 2 segments, the output of the circuit such as that shown in Figures 5A and B represents a partial word result, rather than a true word match line. These partial word results may be combined immediately adjacent to the encoder, as shown in Figures 8A and 8B.

The parameters are summarized as follows:
- The number of word match lines running above each core cell is m
- The number of word match lines plus partial word result lines running above each core cell is i*m/2 (we assume here that i is even, but point out that it could be odd).
- The number of word match lines per physical row, also equal to the number of words per physical row, is 2*m*e.
- The number of inputs to each encoder per row is 2*m.

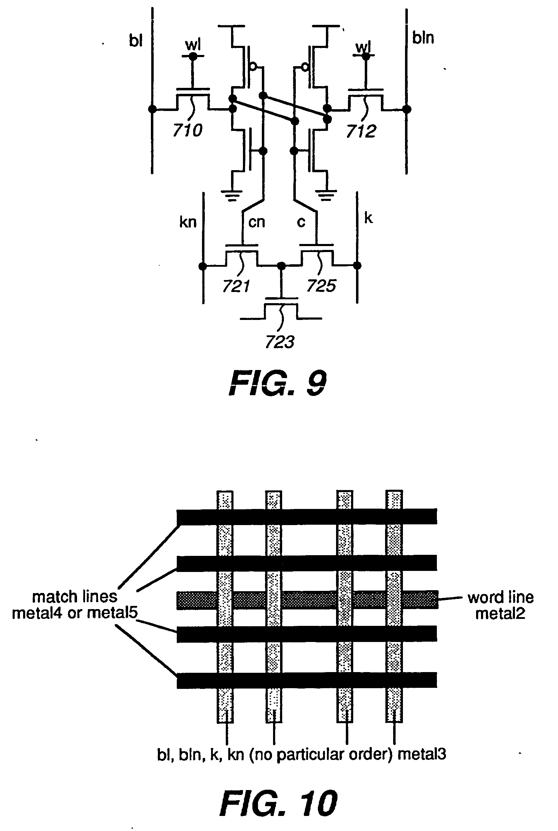

Figure 9 shows an example of the memory core cell 210 of the CAM shown in Figure 2. The core cell shown in Figure 9 is a transistor-level core ceii. The cell is comprised of two cross-coupled inverters between the two static storage nodes, and two access FETs 710 and 712 gated by a word line wl, joining the storage nodes c and on to a pair of bit lines bl and bin. This is a known arrangement for a static SRAM core cell (inverters of P- and N-channel FETs). Other three N-channel FETs 721, 723 and 725 form the comparison portion of the cell. The gate, drain and source of the FET 721 are connected to the negative storage node cn, a negative compare bit line kn and the gate of the FET 723, respectively. The gate, drain and source of the FET 725 are connected to the positive storage node c, a positive comparison bit line k and the gate of the FET 723, respectively. The FET 723 itself forms a part of the match line chain and constitutes the device shown explicitly in Figures 5A and 8A, with its source and drain connected, as appropriate to its location in the chain, to either similar FET in neighbouring cells, or to the circuitry comprising either end of the chain.

The compare bit lines k/kn are separate physical wires from the normal bit line pair bl/bln, running parallel to them in the vertical direction. Employing separate lines decreases the capacitive load on each, hence decreasing power dissipation and increasing speed. It also allows the independent setting of the quiescent states at the storage access devices, and the comparison devices; bl/bln may be kept high during a search, in preparation for the next read or write, and k/kn may be kept high or low during a read or write, in preparation for the next search.

The function achieved by the cell is the combination of (a) the storage of a bit of data, and (b) the switching of a device in the match line chain: on in the case of the compare bit matching the stored bit, and off in the case of the compare bit mismatching the stored bit. In other words, if the binary value stored in the cell at node c, matches the comparand on line k, the FET 723 is conducting. To mask a given bit from the search, one must ensure that it always matches, and that the chain the FET 723 is always conducting; this is done by asserting both k and kn high.

Assuming i = 2 and m = 4, and ignoring the power rails VDD/VSS, the global signal upper-layer metal view of the core cell is shown in Figure 10. All layers from second metal and up are shown. Referring to Figure 10, the layer of the third metals is overlying the layer of the second metal and underneath the layer of the fourth and fifth metals. The second metal is the word line metal (wl). The third metals are the bit line metals (bl and bln) and comparison bit line metals (k and kn). The fourth and fifth metals are the match line metals. The number of horizontal signals in the top layer of metal would be the same for i = 4 and m = 2, or i = 8 and m = 1.

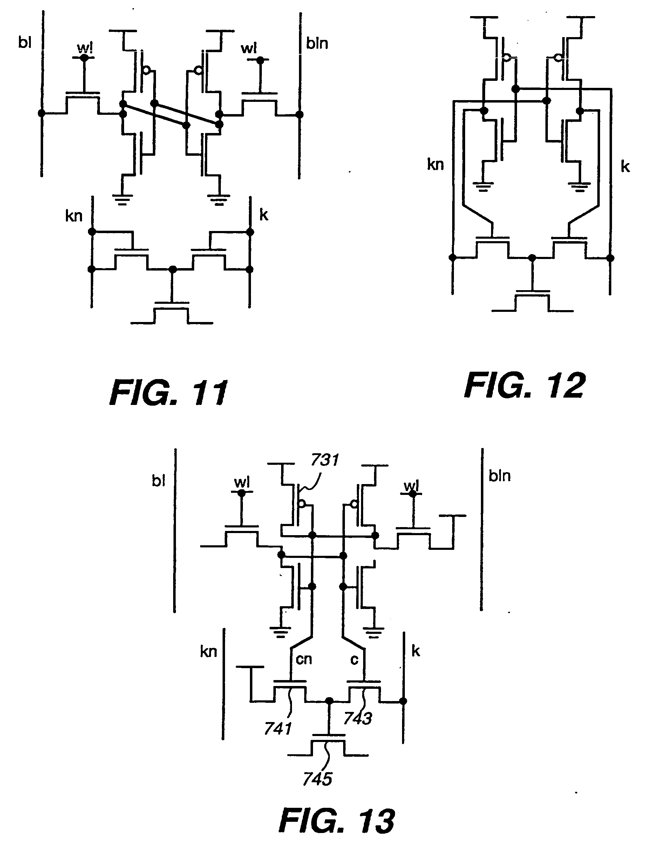

The core cell may be modified, at the transistor level, in three different ways, to yield a cell that always matches; that is, it occupies the same area as a real core cell, and uses transistors of the same size, but the result of the search is guaranteed to be the conduction of the chain device. These three modified core cells are useful in the implementation of a dummy (or model) word or chain, and are shown in Figures 11, 12, and 13. The cell shown in Figure 11 has its chain device continually on - there is never a discharge path for the gate of the chain device. The cell shown in Figure 12 (which is referred to as "conditionally on") matches when either or both of k/kn are high; when both are low, the chain device is off. Two additional devices (not shown) may be included in the cell shown in Figure 12 for the purpose of providing model load on the word line. In Figure 13, node cn is continually pulled up by the diode-connected P-channel FET 731, and is also pulled up to VDD whenever the word line wl is asserted (the VDD connection is not strictly necessary, and may be replaced with a floating drain, depending on which option presents the more convenient layout topology). As a result, node c is held low. The combination of cn high at the gate of a FET 741, and VDD applied at the source of the FET 741, which is connected to a FET 743, results a FET 745 conducting continually, as desired.

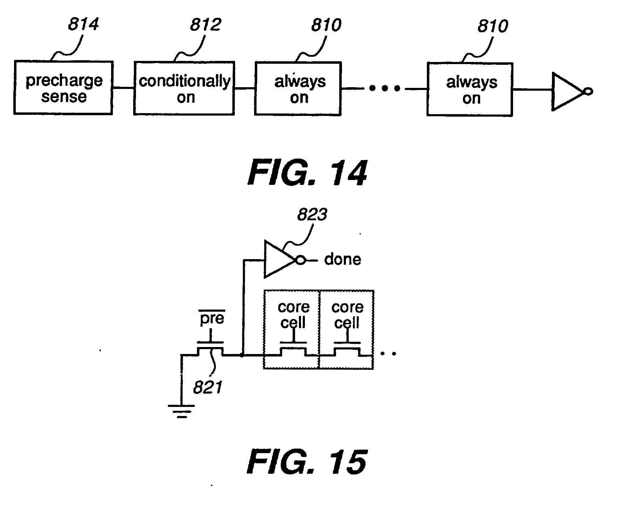

A dummy chain may be used for two purposes. The first purpose is to determine when sufficient time has been allotted for precharge of the chain. A chain that may be used for this purpose is shown in Figure 14. The chain is made up of a number of consecutive "always on" cells 810, such as that shown in Figure 11, a single "conditionally on" cell 812, such as the one shown in Figure 12, and a precharge sense circuit 814, such as the one shown in Figure 15. The precharge sense circuit includes a FET 821 and an inverter. A precharge signal is fed to the gate of the FET 821 and a precharge done signal is provided from the output of the inverter 823. The "conditionally on" cell 812 is included to reflect the condition that precharge cannot be completed until the k/kn signals have been asserted to their valid search voltages. To more properly reflect the propagation delay through the chain as a result of k/kn assertion, the entire dummy chain may be made up of "conditionally on" cells (this implementation is not shown). The precharge sensing dummy chain is not required in all implementations, as is described below.

The second purpose of a dummy chain is as a segment of a dummy word, to determine the time interval for successful evaluation of a match. A word that always matches is used to generate a timing signal which can be used to clock the evaluation of all other match signals. This word may be constructed with the chain as shown in Figure 14, or with all "conditionally on" cells, or with the cells shown in Figure 13. Note that the precharge sense circuit is not required. The timing signal that is generated can further be used to clock the encoder, or as part of a self-timing path for the CAM as a whole. The match evaluation timing dummy word can be used with all implementations.

Note that the CAM architecture results in inherently deterministic search delays. All match lines begin in a mismatch state, and all have equivalent delay to transition to a match state. Hence, in modelling a match, one is guaranteed to be modelling the slowest condition. In the prior art case of a NOR match line, all match lines begin in a match state, and the speed of the transition to a mismatch state depends on the number of bits mismatching. The important timing condition of validity of the match state on the match line must be inferred by observing the slowest possible mismatch.

There are many possible ways to implement a match line chain, in terms of polarity selection, and precharge and evaluation timing and control. The following descriptions cover a variety of the possible implementations, but are not meant to limit the scope of the invention. A person reasonably skilled in the art could devise other similar techniques.

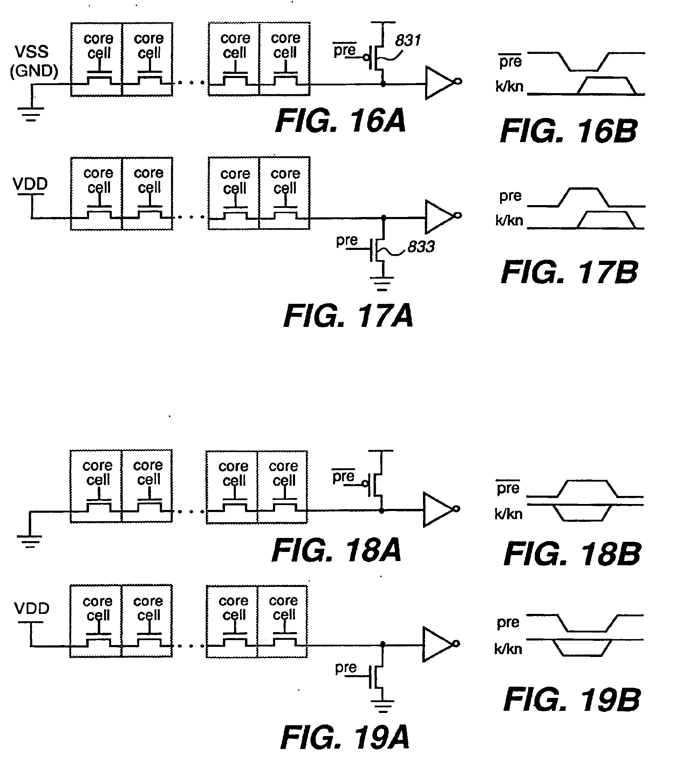

Figures 16A and 16B show a pull-down chain circuit and signal timing of the precharge, respectively. Figures 17A and 17B show a pull-up chain circuit and signal timing of the precharge, respectively. Each of the chain circuits shown in Figures 16A and 17A is used in conjunction with a precharge pulse that occurs after the beginning of the cycle. Precharge pulses are fed to the gates of FETs 831 and 833 which are connected to the chains. To avoid charge-sharing problems following the precharge, precharge must overlap the assertion of valid data on k/kn. A dummy chain for precharge sensing is required to determine when precharge has completed, and to initiate timing of the remainder of the search operation. In the case of a match, there is a very resistive power-GND (or VDD-VSS) path through the entire chain toward the end of the precharge operation.

If the precharge begins at the end of the clock cycle (i.e., if the quiescent state of the signals applied to the chain leaves it in the precharged state), there is no need to sense the completion of precharge before initiating the remainder of the search operation. In this case, precharge completion simply represents a minimum requirement for the cycle time of the CAM. This observation applies to all of the remaining chains described in this disclosure.

The chains shown in Figures 18A and 19A are identical to those of Figures 16A and 17A, except for precharge timing. Note that k/kn are also now in a quiescent high state, allowing complete precharging of all intermediate nodes in the chain. Figure 18A shows this chain designed to implement a pull-down, and Figure 19A shows the same concept with a pull-up. Figures 18B and 19B show precharge timing in the chains shown in Figures 18A and 19A, respectively.

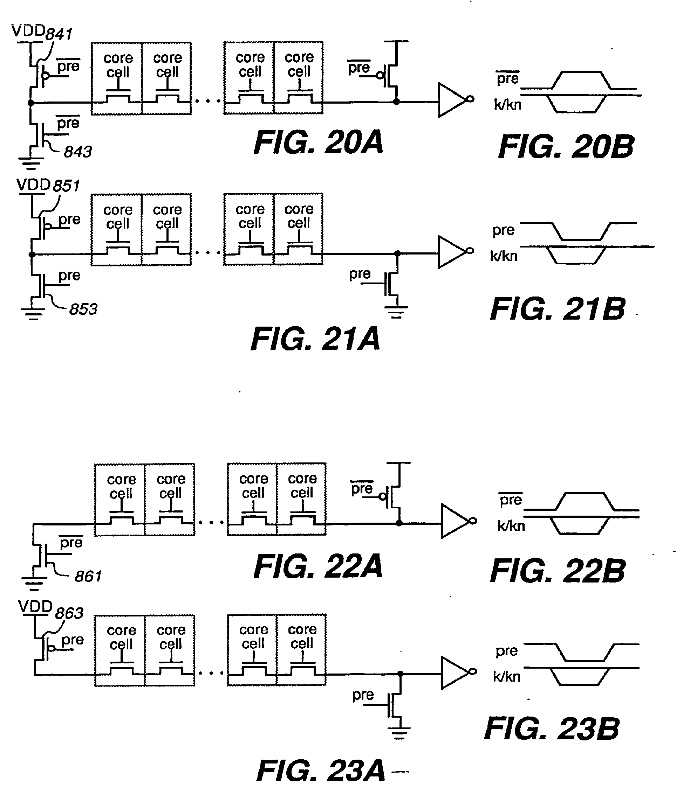

Because precharging from one end of the chain only may be too slow for some applications, precharge devices may be placed at both ends of the chain. This requires the addition of a third device to switch off the evaluation path to the opposite supply during precharge, in order to avoid power-GND current, which would be significant otherwise. Timing is the same as in the case of the chains of Figures 18A and 19A. Figure 20A shows this chain designed to implement a pull-down, and Figure 21 A shows the same concept with a pull-up. The chain shown in Figure 20A has series-connected P- and N-channel FETs 841 and 843 in a power-GND (or VDD-VSS) path, the junction of the FETs being connected to the end of the chain. Similarly, the chain shown in Figure 21A has series-connected P- and N-channel FETs 851 and 853 in a power-GND (or VDD-VSS) path, the junction of the FETs being connected to the end of the chain. Due to FET gating signal selection, neither of these VDD-VSS paths are conductive, except during pre/pre transition. Figures 20B and 21B show precharge timing in the chains shown in Figures 20A and 21A, respectively.

Precharging from a single end of the chain may be fast enough, but the circuits of Figures 18A and 19A may be undesirable due to the resistive power-GND current path in the quiescent precharge state. The chains shown in Figures 22A and 23A solve this problem by including a transistor to prevent evaluation until precharge has completed. Figure 22A shows this chain designed to implement a pull-down, and Figure 23A shows the same concept with a pull-up. The chain shown in Figure 22A has an N-channel FET 861 connected between the end of the chain and the ground. The chain shown in Figure 23A has a P-channel FET 863 connected between the end of the chain and a power VDD terminal. Precharge pulses are fed to the gates of the FETs 861 and 863. Figures 22B and 23B show precharge timing in the chains shown in Figures 22A and 23A, respectively.

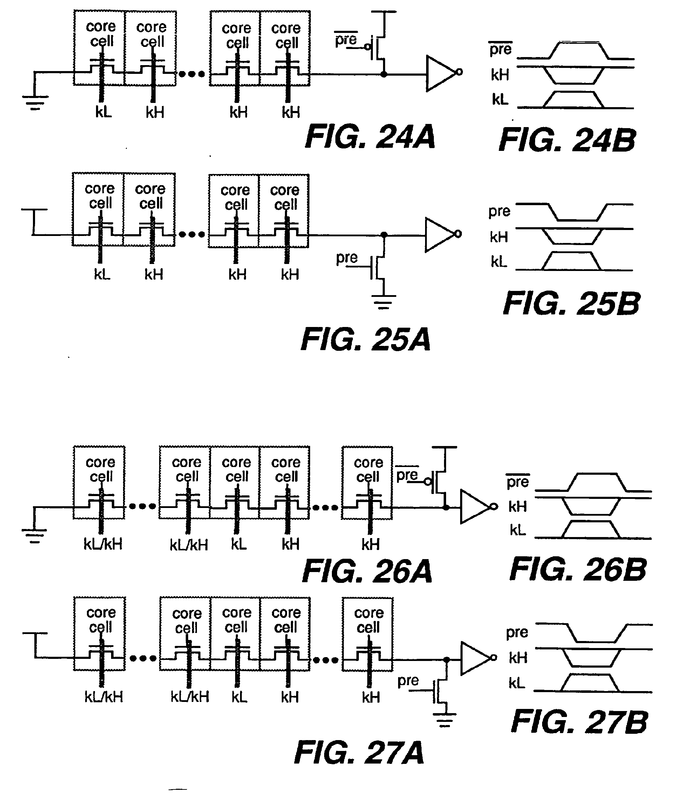

It may be desirable to, at the same time, limit the number of clocked devices in the chain (to limit clocking power), and still remove the possibility of a resistive power-GND short during precharge. It may be preferable to precharge from one end only, as in Figures 18A, 19A, 22A and 23A, but it is preferable to use a data-controlled device to prevent short-circuit current, instead of the clock-controlled device of Figures 22A and 23A. Hence, there are provided circuits that drive the k/kn signals (referred to as "k-drivers") such that the k-drivers corresponding to the column furthest from the precharge device have a quiescent low/low state, rather than high/high, as is the case in the other columns, and as was the case in Figures 18A, 19A, 20A, 21 A, 22A and 23A. The chain design is shown in Figures 24A and 25A, with the two different types of k signals conceptually shown as a single line through the chain device, labelled either kL or kH. Note that the core cell employed is still that of Figure 9, and the k line over the chain device is merely conceptual. Figure 24A shows this chain designed to implement a pull-down, and Figure 25A shows the same concept with a pull-up. Figures 24B and 25B show precharge timing in the chains shown in Figures 24A and 25A, respectively.

With all previous chain designs, it is a design goal to totally eliminate the possibility of charge sharing. If the chain length is not required to be variabie, and is instead fixed, some charge sharing could be tolerable, and may be intentionally designed into the chain. Precharge delay and power can be decreased slightly by leaving a small number of chain nodes unprecharged. This technique is shown in Figures 26A and 27A. The kL column is moved away from the end of the chain opposite the precharge device toward the middle of the chain. Columns to the left of the kL column may be either kL or kH driven. In the statistically unlikely event of a match of all of the bits in the kH columns, but a mismatch in one or more of the other columns, the charge (or lack of charge) on the unprecharged nodes will cause the voltage at the inverter gate to move to an intermediate value which must not be evaluated as a match. If this situation is understood and accounted for, it should be tolerable. Figure 26A shows this chain designed to implement a pull-down, and Figure 27A shows the same concept with a pull-up. Figures 26B and 27B show precharge timing in the chains shown in Figures 26A and 27A, respectively.

In all example designs shown, represented is the match sense circuit as a simple inverter. In fact, this circuit may be implemented as any static or dynamic voltage sense device.

Because some target applications are likely to have a high degree of commonality between matches and mismatches (i.e., they may differ in only a few bits, and have long strings of consecutive bits in common), situations may arise in which excessive power is dissipated in the precharge of these "near-misses". This is especially true if word segments (entire chains) match in mismatched words. Note that this situation has no counterpart in traditional wired-NOR match line CAMs.

One example of the above situation (not intended to limit applicability) is in ATM address look-up. The address is composed of two fields: Virtual Channel Identifier (VCI) and Virtual Path Identifier (VPI). Many entries may (a) have identical VPIs, and differ in a few bits of the VCI, or (b) have identical VCls, and differ in a few bits of the VPI. In order to limit power dissipation in this event, it is beneficial to scramble the order of the bits in the chain.

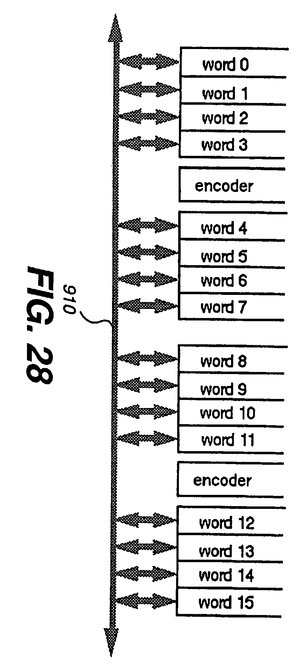

In most memories, columns are organized in a bit-sliced fashion, such that all columns associated with a given data bit are grouped together. The architecture described in this disclosure is word-sliced, as shown in Figure 28, instead of bit-sliced. Because of this, a global data bus 910, joining all words (that is, joining all columns associated with each of the bits) is required. Some observations about this bus:
- The bus 910 may be used for search, read or write operations, supplying bi-directional data.
- All drivers onto the bus 910 must be tri-statable.

Although particular embodiment of the present invention have been described in detail, it should be appreciated that numerous variations, modifications, and adaptations may be made without departing from the scope of the present invention as defined in the claims.

## Claims

1. A content addressable memory, hereinafter referred to as a CAM, comprising:
w words of matching means, each word comprising b core cells arranged into i match line chain segments, each match line chain segment comprising b/i core ceiis (210), each core cell (210) comprising means for storing data, w, i. b and b/i being integers, i and b/i being greater than or equal to two;
AND or NAND logic means (218, 220) for logically coupling the match line chain segments in a respective word; and
encoding means (218) for providing search results based on the outputs from the logic means,
**characterised in that**:
the core cells of each match line chain segment are chained in series by a match line (212); and
the order of bits in a word is deterministically scrambled among different match line chain segments making up said word.

2. The CAM of claim 1, wherein the logic means (218, 220) comprises NAND circuit means which provides iogicai outputs in response to the outputs from the match line chain segments in a respective row.

3. The CAM of claim 1, further comprising means for sensing the transitions of data signals on the chains.

4. The CAM of claim 3, wherein the polarity of data signal swings to signify a match is up or down.

5. The CAM of claim 1, wherein i=2 and a pair of match line chain segments are oriented in mirror images, such that their outputs face each other, facilitating the logic combination of the two partial match results from the two chain segments, by a logic means (218, 220).

6. The CAM of claim 5, wherein the logic means (218, 220) comprises AND logic means (220) and the word match lines (224), resulting from the ANDing of partial match results on the match line chain segments, one word match line (224) per word, are routed so as to convey the match result to the encoding means (222).

7. The CAM of claim 6, wherein the word match lines (224) are selectively routed physically over the core cells (210) in a metal layer above all other signals used in the core cell (210).

8. The CAM of claim 6, wherein the encoding means (222) comprises a plurality of encoders.

9. The CAM of claim 6, wherein multiple words are placed adjacent to the encoding means (222), with multiple word match lines (224) running over each core cell, allowing multiple word match lines (224) to be routed per row.

10. The CAM of claim 9, wherein the word match lines (224) are selectively routed over the core cells (210) in a metal layer above all other signals used in the core cell (210).

11. The CAM of claim 6, wherein the partial match results are selectively routed above the core cell (210), to be combined in the AND logic means (220).

12. The CAM of claim 11, wherein the results from pairs of match line chain segments (212) are first combined by a logical AND operation into a secondary partial result, the result then being routed above the core cell (210), to be combined in a final AND gate adjacent to the (222) encoder.

13. The CAM of claim 1, wherein the core cell (210) comprises a plurality of field effect transistors, hereinafter referred to as FETs, for data storing operations, and further comprising logic level/precharging means for supplying a first binary logic level to one end of the chain segments and for precharging the match line chain segment to a second binary logic level in response to a clock signal.

14. The CAM of claim 13, wherein the logic level/precharging means comprises means for tying the one end of the chain segment directly to a power supply of the first binary logic level.

15. The CAM of claim 13, wherein the logic level/precharging means comprises a first FET at the other end of the chain nearest match sense circuitry.

16. The CAM of claim 15, wherein the logic level/precharging means further comprises means for precharging the chain segment to the second binary logic level, commencing following the beginning of the clock cycle during which the search is to be performed, by the first FET.

17. The CAM of claim 15, wherein the logic level/precharging means further comprises means for precharging the chain segment to the second binary logic level, commencing following the completion of search operation, continuing during the non-searching quiescent state of the CAM, and ceasing prior to the initiation of the next search operation, by the first FET, the chain segment's FETs being in a conducting state during precharge, due to the high logic level on their gates.

18. The CAM of claim 13, wherein the logic level/precharging means comprises the first FET at one end of the chain segment and a second FET at the other end of the chain segment farthest from match sense circuitry.

19. The CAM of claim 18, wherein the logic level/precharging means comprises means for connecting the one end of the chain to a power supply of the first binary logic level, by a third FET which is made conducting when the first and second FET are non-conducting, the chain's FETs being in a conducting state during precharge, due to the high logic level on their gates.

20. The CAM of claim 18, wherein the second FET is conducting when the first FET is non-conducting.

21. The CAM of claim 13, wherein,
the logic level/precharging means comprises logic level means and precharging means,
the precharging means comprising means for precharging the chain segment to the second binary logic level, commencing following the completion of the search operation, continuing during the non-searching quiescent state of the CAM, and ceasing prior to the initiation of the next search operation, by a first FET at the end of the chain segment nearest match sense circuitry;
the logic level means being for directly tying the one end of the chain segment to a power supply of the first binary logic level; and
the core cell in the chain at the extreme one end to the match sense circuitry comprising FETs identical to those of the other core cells in the chain segment, the compare data being applied at the opposite polarity during the quiescent precharge state, such that the chain segment's FET is the only such FET in the chain which is non-conducting in the quiescent precharge state.

22. The CAM of claim 13, wherein,
the logic level/precharging means comprises logic level means and precharging means,
the precharging means being for precharging the chain to the second binary logic level, commencing following the completion of the search operation, continuing during the non-searching quiescent state of the CAM, and ceasing prior to the initiation of the next search operation, by a first FET at the end of the chain segment nearest match sense circuitry,
the logic level means being for directly tying the chain segment to a power supply of the first binary logic level,
the core cell at a predetermined and constant location in the chain segment comprising FETs identical to those of the other core cells in the chain, the compare data being applied at the opposite polarity during the quiescent precharge state, such that the chain segment's FET is the only such FET in the chain segment which is non-conducting in the quiescent precharge state, thereby any charge sharing occurring during the search of the chain segment tending to make a mismatch appear somewhat like a match, but with the degree of the charge sharing understood and accounted for.

23. The CAM of claim 13, wherein the core cell (210) comprises:
first and second N-channel FETs and first and second P-channel FETs forming two cross-coupled inverters for storing differential data;
third and fourth N-channel FETs (710, 712) coupled with the differential data nodes to differential bit lines, the FETs being gated by a word line, so as to provide access for read and write data operations;
a fifth N-channel FET (723);
sixth and seventh N-channel FETs (721, 725), either of them being gated by the positive storage node and for connecting a positive comparison bit line to the gate of the fifth N-channel FET 723), the other being gated by the negative storage node and for connecting a negative comparison bit line to the gate of the fifth N-channel FET (723), the comparison bit lines being physically distinct from the bit lines employed for read and write access, the source and drain of the fifth N-channel FET (723) being connected to those of neighbouring cells to form a chain segment of such FETs.

24. The CAM of claim 1, further comprising a dummy match line chain segment comprising an array of data store CAM cells coupled with bit lines.

25. The CAM of claim 24, wherein each CAM cell of the dummy match line chain segment is a model CAM cell, which is guaranteed to match and has its chain FET conducting, the model CAM cell comprising:
a combination of two N-channel FETs and two P-channel FETs forming two cross-coupled inverters, implementing static differential data storage;
two additional N-channel FETs, connecting the static differential data nodes to differential bit lines, gated by a word line, for the purpose of providing access for read and write operations;
two further N-channel FETs, one being gated by a positive comparison bit line, and connecting a positive comparison bit line to the gate of a third further N-channel FET, the other being gated by a negative comparison bit line, and connecting a negative comparison bit line to the gate of the same third further N-channel FET;
comparison bit lines being physically distinct from the bit lines employed for read and write access;
third further N-channel FET, its gate connected as described above, with source and drain connected to like transistors in neighbouring cells to form a chain of such devices.

26. The CAM of claim 24, wherein each CAM cell of the dummy match line chain is a model CAM cell, which is guaranteed to match when one of the comparison bit lines is in a logical high state, and has its chain segment FET conducting in that case, the model CAM cell comprising:
two optional N-channel FETs, with drain and source unconnected, gated by a word line, for the purpose of providing model loading to the word line;
a combination of an N-channel FET and a P-channel FET forming an inverter, inverting the logical state of a positive comparison bit line;
a combination of an N-channel FET and a P-channel FET forming an inverter, inverting the logical state of a negative comparison bit line;
two further N-channel FETs, one being gated by the inverted positive comparison bit line, and connecting the negative comparison bit line to the gate of a third further N-channel FET, the other being gated by the inverted negative comparison bit line, and connecting the positive comparison bit line to the gate of the same third further N-channel FET;
third further N-channel FET, its gate connected as described above, with source and drain connected to like transistors in neighbouring cells (or to appropriate other circuits in the boundary cases) to form a chain of such devices.

27. The CAM of claim 24, wherein each CAM cell of the dummy match line chain segment is a model CAM cell, which is guaranteed to match and has its chain segment FET conducting, the model cell comprising:
a pair of differential bit lines, selectively included, but electrically unconnected to the remainder of the core cell;
a negative comparison bit line, selectively included, but electrically unconnected to the remainder of the core cell;
two N-channel FETs, connecting the static differential storage nodes to: the positive supply voltage, in the case of the negative static storage node, and a floating source, in the case of the positive static storage node, gated by a word line;
a first P-channel FET, it source connected to the positive supply voltage, and its gate and drain connected together to the negative static storage node, which is kept in a logical high state by the arrangement;
a third N-channel FET, its source connected to the negative supply voltage, its gate connected to the negative static storage node, said node pulled high by the first P-channel FET, resulting in its conduction such that its drain, connected to the positive static storage node, is kept in a logical low state by the arrangement;
a second P-channel FET, its source connected to the positive supply voltage, its gate connected to the positive static storage node, said node being kept in a logical low state by the third N-channel FET as described above, resulting in its conduction such that its drain, connected to the negative static storage node, is reinforced in its logical high state imposed by the first P-channel transistor, described above;
a fourth N-channel FET, its source connected to the negative supply voltage, its gate connected to the positive static storage node, resulting in it being in a non-conducting state, and its drain electrically unconnected to any other node;
two further N-channel FETs: the first gated by the positive static storage node, and connecting a positive comparison bit line to the gate of a third further N-channel FET, said device being in a non-conducting state due to the logical low state of its gate; the second gated by the negative static storage node, and connecting the positive supply voltage to the gate of the same third further N-channel FET, said device being in a conducting state due to the logical high state of its gate;
any comparison bit line or lines present being physically distinct from any present bit line or lines employed for read and write access;
third further N-channel FET, its gate connected as described above and in a high state, the FET being in a conducting state, with source and drain connected to like transistors in neighbouring cells to form a chain of such devices.

28. The CAM of claim 27, wherein in each model CAM cell, either or both of the (i) positive supply voltage connection to the transistor gated by the word line and also connected to the negative static storage node, and the (ii) positive comparison bit line connection to the first further N-channel FET, may be replaced with a floating or unconnected node.

29. The CAM of claim 27, wherein in each model CAM cell, all differential nodes are substituted by their corresponding complementary polarities of positive and negative for negative and positive, respectively.

30. The CAM of claim 28, wherein in each model CAM cell, all differential nodes are substituted by their corresponding complementary polarities of positive and negative for negative and positive, respectively.

31. The CAM of claim 1, further comprising a dummy chain segment for determining when precharge of all chains is complete, the dummy chain segments comprising as many dummy cells as the core cells of an actual storage chain segment, the dummy chain segment always conducting to model a match, responding to compare bit line transitions in the same way as a real chain segment with a match, the dummy chain segment comprising means for detecting when precharge is complete, at its end opposite precharge circuitry.

32. The CAM of claim 1, further comprising a dummy word for determining when sufficient time has elapsed for a match to complete, wherein
the word is segmented into the same number of chain segments as an actual word of storage;
each chain segment has the same number of cells as an actual storage chain segment, but composed of dummy core cells, instead of real core cells;
each chain segment always conducts to model a match, and responding to compare bit line transitions in the same way as a real chain segment with a match.

33. The CAM of claim 1, further comprising a global data bus, connecting peripheral circuitry to the words of the CAM, wherein the bus joins all words and is used for search, read or write operations, supplying bi-directional data, and all drivers onto the bus are tri-statable.

## Patentansprüche

1. Inhaltsadressierbarer Speicher, der nachfolgend als ein CAM bezeichnet wird, mit:
w Worten von Übereinstimmungs-Einrichtungen, wobei jedes Wort b Kernzellen umfasst, die in i Trefferleitungs-Kettensegmenten angeordnet sind, wobei jedes Trefferleitungs-Kettensegment b/i Kernzellen (210) umfasst, wobei jede Kernzelle (210) Einrichtungen zum Speichern von Daten umfasst, wobei w, i, b und b/i ganze Zahlen sind und i und w/i größer oder gleich zwei sind;
UND- oder NICHT-UND-Logikeinrichtungen (218, 220) zum logischen Koppeln der Trefferleitungs-Kettensegmente in einem jeweiligen Wort; und
Codiereinrichtungen (218) zur Lieferung von Suchergebnissen auf der Grundlage der Ausgänge der Logikeinrichtungen,
**dadurch gekennzeichnet, dass**:
die Kernzellen jedes Trefferleitungs-Kettensegmentes in Serie durch eine Trefferleitung (212) in einer Kette angeordnet sind; und
die Reihenfolge der Bits in einem Wort zwischen unterschiedlichen Trefferleitungs-Kettensegmenten, die das genannte Wort bilden, deterministisch verwürfelt ist.

2. CAM nach Anspruch 1, bei dem die Logikeinrichtung (218, 220) Nicht-Und-Schaltungseinrichtungen umfasst, die logische Ausgänge in Abhängigkeit von den Ausgängen von den Trefferleitungs-Kettensegmenten in einer jeweiligen Reihe liefern.

3. CAM nach Anspruch 1, der weiterhin Einrichtungen zum Messen der Übergänge der Datensignale auf den Ketten umfasst.

4. CAM nach Anspruch 3, bei dem die Polarität der Datensignal-Ausschläge zur Anzeige eines Treffers nach oben oder nach unten verläuft.

5. CAM nach Anspruch 1, bei dem i=2 ist und ein Paar von Trefferleitungs-Kettensegmenten in Spiegelbildern angeordnet ist, derart, dass ihre Ausgänge aufeinander gerichtet sind, wodurch die logische Kombination der Teil-Trefferergebnisse von den zwei Kettensegmenten durch eine Logikeinrichtung (218, 220) erleichtert ist.

6. CAM nach Anspruch 5, bei dem die Logikeinrichtung (218, 220) UND-Logikeinrichtungen (220) umfasst und die Wort-Trefferleitungen (224), die sich aus der UND-Verknüpfung der Teil-Trefferergebnisse auf den Trefferleitungs-Kettensegmenten ergeben, bei einer Wort-Trefferleitung (224) pro Wort, so geführt sind, dass sie das Trefferergebnis an die Codiereinrichtung (222) weiterleiten.

7. CAM nach Anspruch 6, bei dem die Wort-Trefferleitungen (224) selektiv physikalisch über die Kernzellen (210) in einer Metallschicht oberhalb aller anderen Signale geführt sind, die in der Kernzelle (210) verwendet werden.

8. CAM nach Anspruch 6, bei dem die Codiereinrichtung (222) eine Vielzahl von Codierern umfasst.

9. CAM nach Anspruch 6, bei dem mehrfache Worte benachbart zu der Codiereinrichtung (222) angeordnet sind, wobei mehrfache Wort-Trefferleitungen (224) über jede Kernzelle laufen und es ermöglichen, dass mehrfache Wort-Trefferleitungen (224) pro Reihe geführt werden.

10. CAM nach Anspruch 9, bei dem die Wort-Trefferleitungen (224 selektiv über die Kernzellen (210) in einer Metallschicht oberhalb aller anderen Signale geführt sind, die in der Kernzelle (210) verwendet werden.

11. CAM nach Anspruch 6, bei dem die Teil-Trefferergebnisse selektiv oberhalb der Kernzelle (210) geführt sind, um in den UND-Logikeinrichtungen (220) kombiniert zu werden.

12. CAM nach Anspruch 11, bei dem die Ergebnisse von Paaren der Trefferleitungs-Kettensegmente (212) zunächst durch eine logische UND-Operation in ein sekundäres Teilergebnis kombiniert werden, wobei das Ergebnis dann oberhalb der Kernzelle (210) geführt wird, um in einem abschließenden UND-Verknüpfungsglied benachbart zu dem Codierer (222) kombiniert zu werden.

13. CAM nach Anspruch 1, bei dem die Kernzelle (210) eine Anzahl von Feldeffekttransistoren, die nachfolgend als FETs bezeichnet werden, für Datenspeicheroperationen umfasst, und weiterhin Logikpegel-Vorladungs-Einrichtungen zur Lieferung eines ersten binären Logikpegels an ein Ende der Kettensegmente und zum Vorladen des Trefferleitungs-Kettensegmentes auf einen zweiten binären Logikpegel in Abhängigkeit von einem Taktsignal vorgesehen sind.

14. CAM nach Anspruch 13, bei dem die Logikpegel/Vorladungs-Einrichtungen Einrichtungen zum Binden eines Endes des Kettensegmentes direkt an eine Leistungsversorgung des ersten binären Logikpegels umfassen.

15. CAM nach Anspruch 13, bei dem die Logikpege/Vorladungs-Einrichtung einen ersten FET an dem anderen Ende der Kette nächstgelegen zur Treffer-Messschaltung umfasst.

16. CAM nach Anspruch 15, bei dem die Logikpegel-Vorladungs-Einrichtung weiterhin Einrichtungen zum Vorladen des Kettensegmentes durch den ersten FET auf den zweiten binären Logikpegel beginnend nach dem Beginn des Taktzyklus umfasst, während-dessen die Suche ausgeführt werden soll,.

17. CAM nach Anspruch 15, bei dem die Logikpegel-Vorladungs-Einrichtung weiterhin Einrichtungen zum Vorladen des Kettensegmentes auf den zweiten binären Logikpegel, beginnend nach dem Abschluss der Suchoperation und fortgesetzt während des Ruhezustandes des CAM ohne Suche und beendigt vor der Einleitung der nächsten Suchoperation, durch den ersten FET umfasst, wobei die FETs des Kettensegmentes während der Vorladung aufgrund des hohen Logikpegels an ihren Gates sich in einem leitenden Befinden.

18. CAM nach Anspruch 13, bei dem die Logikpege/Vorladungs-Einrichtung einen ersten FET an einem Ende des Kettensegmentes und einen zweiten FET an dem anderen Ende des Kettensegmentes umfasst, der am weitesten von der Treffer-Messschaltung entfernt ist.

19. CAM nach Anspruch 18, bei dem die Logikpegel/Vorladungs-Einrichtung Einrichtungen zum Verbinden des einen Endes der Kette mit einer Leistungsversorgung des ersten binären Logikpegels über einen dritten FET umfasst, der leitend gemacht wird, wenn die ersten und zweiten FETs nicht leitend sind, wobei die FETs der Kette sich während der Vorladung aufgrund des hohen Logikpegels an ihren Gate-Anschlüssen in einem leitenden Zustand befinden.

20. CAM nach Anspruch 18, bei dem der zweite FET leitet, wenn der erste FET nicht leitend ist.

21. CAM nach Anspruch 13, bei dem
die Logikpegel/Vorladungs-Einrichtung Logikpegel-Einrichtungen und Vorlade-Einrichtungen umfasst,
die Vorladungs-Einrichtungen Einrichtungen zum Vorladen des Kettensegmentes auf dem zweiten binären Logikpegel beginnend nach dem Abschluss der Suchoperation, fortgesetzt während des Ruhezustandes des CAM ohne Suche und beendigt vor der Einleitung der nächsten Suchoperation durch einen ersten FET an dem Ende des Kettensegmentes nächst benachbart zur Treffer-Messschaltung umfasst;
die Logikpegel-Einrichtungen zum direkten Binden des einen Endes des Kettensegmentes an eine Leistungsversorgung mit dem ersten binären Logikpegel dient; und
die Kernzelle in der Kette an dem äußeren einen Ende zu der Treffer-Messschaltung FETs umfasst, die identisch zu denen der anderen Kernzelle in dem Kettensegment sind, wobei die Vergleichsdaten mit der entgegengesetzten Polarität während des Vorladungs-Ruhezustandes angelegt werden, derart, dass der FET der Kettensegmente der einzige derartige FET in der Kette ist, der in dem Vorladungs-Ruhezustand nicht leitend ist.

22. CAM nach Anspruch 13, bei dem
die Logikpegel/Vorladungs-Einrichtung Logikpegel-Einrichtungen und Vorladungs-Einrichtungen umfasst,
die Vorladungs-Einrichtung zum Vorladen der Kette auf den zweiten binären Logikpegel beginnend nach dem Abschluss der Suchoperation, fortgesetzt während des Ruhezustandes des CAM ohne Suche und beendet vor der Einleitung der nächsten Suchoperation, durch einen ersten FET an dem Ende des Kettensegmentes nächstgelegen zur Treffer-Messschaltung dient,
die Logikpegel-Einrichtung zum direkten Binden des Kettensegmentes an eine Leistungsversorgung mit dem ersten binären Logikpegel dient,
die Kernzelle an einer vorgegebenen und konstanten Position in dem Kettensegment FETs umfasst, die identisch zu denen der anderen Kernzellen in der Kette sind, wobei die Vergleichsdaten mit der entgegengesetzten Polarität während des Vorladungs-Ruhezustandes derart angelegt werden, dass der FET des Kettensegmentes der einzige derartige FET in dem Kettensegment ist, der in dem Vorladungs-Ruhezustand nicht leitend ist, wodurch jede Ladungsteilung, die während der Suche des Kettensegmentes auftritt und dahingehend wirkt, dass eine fehlende Übereinstimmung etwas wie eine Übereinstimmung erscheint, wobei jedoch der Grad der Ladungsteilung verstanden und berücksichtigt wird.

23. CAM nach Anspruch 13, bei dem die Kernzelle (210) Folgendes umfasst:
erste und zweite N-Kanal-FETs und erste und zweite P-Kanal-FETs, die zwei kreuzgekoppelte Inverter zum Speichern von Differenzdaten bilden;
dritte und vierte N-Kanal-FETs (710, 712), die mit den Differenzdaten-Knoten an Differenz-Bitleitungen gekoppelt sind, wobei die FETs durch eine Wortleitung Gate-gesteuert sind, um einen Zugang für Lese- und Schreib-Datenoperationen zu schaffen;
einen fünften N-Kanal-FET (723);
sechste und siebte N-Kanal-FETs (721, 725), von denen einer durch den positiven Speicherknoten Gate-gesteuert ist und zum Verbinden einer positiven Vergleichs-Bitleitung mit dem Gate des fünften N-Kanal-FET (723) dient, während der andere durch den negativen Speicherknoten Gate-gesteuert wird und zum Verbinden einer negativen Vergleichs-Bitleitung mit dem Gate des fünften N-Kanal-FET (723) dient, wobei die Vergleichs-Bitleitungen physikalisch getrennt von den Bitleitungen sind, die für den Lese- und Schreibzugriff verwendet werden, wobei die Source-und Drain-Anschlüsse des fünften N-Kanal-FET (723) mit denen von benachbarten Zellen verbunden sind, um ein Kettensegment derartiger FETs zu bilden.

24. CAM nach Anspruch 1, der weiterhin ein Blind-Trefferleitungs-Kettensegment umfasst, das eine Anordnung von Datenspeicher-CAM-Zellen umfasst, die mit Bitleitungen gekoppelt sind.

25. CAM nach Anspruch 24, bei dem jede CAM-Zelle des Blind-Trefferleitungs-Kettensegmentes eine Modell-CAM-Zelle ist, bei der ein Treffer garantiert ist und deren Ketten-FET leitet, wobei die Modell-CAM-Zelle Folgendes umfasst:
eine Kombination von zwei N-Kanal-FETs und zwei P-Kanal-FETs, die zwei kreuzgekoppelte Inverter bilden und eine statische Differenzdaten-Speicherung implementieren;
zwei zusätzliche N-Kanal-FETs, die die statischen Differenzdaten-Knoten mit Differenz-Bit-Leitungen verbinden und durch eine Wortleitung Gate-gesteuert werden, um einen Zugang für Lese-und Schreiboperationen zu schaffen;
zwei weitere N-Kanal-FETs, von denen einer durch eine positive Vergleichs-Bitleitung Gate-gesteuert ist und eine positive Vergleichs-Bitleitung mit dem Gate eines dritten weiteren N-Kanal-FET verbindet, während der andere durch eine negative Vergleichs-Bitleitung Gate-gesteuert ist und eine negative Vergleichs-Bitleitung mit dem Gate des gleichen dritten weiteren N-Kanal-FET verbindet;
Vergleichs-Bitleitungen, die physikalisch getrennt von den Bitleitungen sind, die für den Lese- und Schreibzugriff verwendet werden;
einen dritten weiteren N-Kanal-FET, dessen Gate in der vorstehend beschriebenen Weise verbunden ist, wobei die Source- und Drain-Anschlüsse mit gleichen Transistoren in benachbarten Zellen verbunden sind, um eine Kette derartiger Bauteile zu bilden.

26. CAM nach Anspruch 24, bei dem jede CAM-Zelle der Blind-Trefferleitungs-Kette eine Modell-CAM-Zelle ist, bei der eine Übereinstimmung garantiert ist, wenn eine der Vergleichs-Bitleitungen einen logischen hohen Zustand aufweist, und dessen Kettensegment-FET in diesem Fall leitet, wobei die Modell-CAM-Zelle Folgendes umfasst:
zwei optionale N-Kanal-FETs, deren Drain- und Source-Anschlüsse nicht verbunden sind und die durch eine Wortleitung Gate-gesteuert sind, um eine Modell-Ladung der Wortleitung zu schaffen;
eine Kombination eines N-Kanal-FET und eines P-Kanal-FET, die einen Inverter bilden, der den logischen Zustand einer positiven Vergleichs-Bitleitung invertiert;
eine Kombination eines N-Kanal-FET und eines P-Kanal-FET, die einen Inverter bilden, der den logischen Zustand einer negativen Vergleichs-Bitleitung invertiert;
zwei weitere N-Kanal-FETs, von denen einer durch die invertierte positive Vergleichs-Bitleitung Gate-gesteuert ist und die negative Vergleichs-Bitleitung mit dem Gate eines dritten weiteren N-Kanal-FET verbindet, während der andere durch die invertierte negative Vergleichs-Bitleitung Gate-gesteuert wird und die positive Vergleichs-Bitleitung mit dem Gate des gleichen dritten weiteren N-Kanal-FET verbindet;
einen dritten weiteren N-Kanal-FET, dessen Gate in der vorstehend beschriebenen Weise verbunden ist, wobei die Source- und Drain-Anschlüsse mit gleichen Transistoren in benachbarten Zellen (oder mit passenden anderen Schaltungen in den Grenzfällen) verbunden sind, um eine Kette derartiger Bauteile zu bilden.

27. CAM nach Anspruch 24, bei dem jede CAM-Zelle des Blind-Trefferleitungs-Kettensegmentes eine Modell-CAM-Zelle ist, bei der eine Übereinstimmung garantiert ist und deren Kettensegment-FET leitet, wobei die Modell-Zelle Folgendes umfasst:
ein Paar von Differenz-Bitleitungen, die selektiv eingeschlossen, jedoch elektrisch mit dem Rest der Kernzelle unverbunden sind;
eine negative Vergleichs-Bitleitung, die selektiv eingeschlossen ist, jedoch elektrisch unverbunden mit dem Rest der Kernzelle ist;
zwei N-Kanal-FETs, die die statischen Differenz-Speicherknoten mit Folgendem verbinden:
der positiven Versorgungsspannung in dem Fall des negativen statischen Speicherknotens, und einer schwimmenden Quelle in dem Fall des positiven statischen Speicherknotens, Gate-gesteuert durch eine Wortleitung;
einen ersten P-Kanal-FET, dessen Source mit der positiven Versorgungsspannung verbunden ist, und dessen Gate und Drain miteinander und mit dem negativen statischen Speicherknoten verbunden sind, der durch die Anordnung in einem logischen hohen Zustand gehalten wird;
einen dritten N-Kanal-FET, dessen Source mit der negativen Versorgungsspannung verbunden ist, dessen Gate mit dem negativen statischen Speicherknoten verbunden ist, wobei der Knoten durch den ersten P-Kanal-FET auf einen hohen Pegel gezogen wird, was zu dessen leitendem Zustand derart führt, dass ein Drain-Anschluss, der mit dem positiven statischen Speicherknoten verbunden ist, durch die Anordnung auf einem logischen niedrigen Zustand gehalten wird,
einen zweiten P-Kanal-FET, dessen Source-Anschluss mit der positiven Versorgungsspannung verbunden ist, dessen Gate-Anschluss mit dem positiven statischen Speicherknoten verbunden ist, wobei der Knoten durch den dritten N-Kanal-FET in der vorstehend beschriebenen Weise auf einem logisch niedrigen Zustand gehalten wird, was zu dessen leitendem Zustand führt, derart, dass dessen Drain-Anschluss, der mit dem negativen statischen Speicherknoten verbunden ist, in seinem logisch hohen Zustand verstärkt wird, der durch den ersten P-Kanal-Transistor aufgeprägt wird, wie dies vorstehend beschrieben wurde;
einen vierten N-Kanal-FET, dessen Source-Anschluss mit der negativen Versorgungsspannung verbunden ist, dessen Gate-Anschluss mit dem positiven statischen Speicherknoten verbunden ist, was dazu führt, dass er sich in einem nicht leitenden Zustand befindet, und dessen Drain-Anschluss elektrisch unverbunden mit irgendeinem anderen Knoten ist;
zwei weitere N-Kanal-FETs: wobei der erste durch den positiven statischen Speicherknoten Gate-gesteuert ist und eine positive Vergleichs-Bitleitung mit dem Gate eines dritten weiteren N-Kanal-FET verbindet, wobei sich das Bauteil in einem nicht leitenden Zustand aufgrund des logisch niedrigen Zustandes seines Gate-Anschlusses befindet; während der zweite durch den negativen statischen Speicherknoten Gate-gesteuert ist und die positive Versorgungsspannung mit dem Gate des gleichen dritten weiteren N-Kanal-FET verbindet, wobei sich das Bauteil aufgrund des logisch hohen Zustandes seines Gate-Anschlusses in einem leitenden Zustand befindet;
wobei irgendeine Vergleichs-Bitleitung oder Leitungen, die vorhanden sind, physikalisch getrennt von irgendeiner vorhandenen Bitleitung oder Leitungen sind, die für einen Lese- und Schreibzugriff verwendet werden;
ein dritter weiterer N-Kanal-FET, dessen Gate in der vorstehend beschriebenen Weise verbunden ist, wobei in einem hohen Zustand der FET sich in einem leitenden Zustand befindet, wobei die Source- und Drain-Anschlüsse mit gleichen Transistoren in benachbarten Zellen verbunden sind, um eine Kette derartiger Bauteile zu bilden.

28. CAM nach Anspruch 27, bei dem in jeder Modell-CAM-Zelle eine oder beide von (i) der positiven Versorgungsspannungs-Verbindung zu dem durch die Wortleitung Gate-gesteuerten Transistor, der außerdem mit dem negativen statischen Speicherknoten verbunden ist, und (ii) der positiven Vergleichs-Bitleitungs-Verbindung zu dem ersten weiteren N-Kanal-FET durch einen schwimmenden oder nicht angeschlossenen Knoten ersetzt werden können.

29. CAM nach Anspruch 27, bei dem in jeder Modell-CAM-Zelle alle Differenz-Knoten durch ihren entsprechenden komplementären Polaritäten von positiv und negativ durch negativ bzw. positiv ersetzt sind.

30. CAM nach Anspruch 28, bei dem in jeder Modell-CAM-Zelle alle Differenz-Knoten durch ihre entsprechenden komplementären Polaritäten von positiv und negativ durch negativ bzw. positiv ersetzt sind.

31. CAM nach Anspruch 1, der weiterhin ein Blind-Kettensegment zur Feststellung, wann die Vorladung aller Ketten abgeschlossen ist, umfasst, wobei die Blind-Kettensegmente so viele Blind-Zellen wie Kernzellen eines tatsächlichen Speicher-Kettensegmentes umfassen, wobei das Blind-Kettensegment immer leitet, um eine Übereinstimmung zu modellieren und auf Vergleichs-Bitleitungs-Übergänge in der gleichen Weise wie ein tatsächliches Kettensegment mit einer Übereinstimmung oder einem Treffer anspricht, wobei das Blind-Kettensegment Einrichtungen zum Feststellen, wann eine Vorladung abgeschlossen ist, an ihrem Ende gegenüberliegend zur Vorladungsschaltung umfasst.

32. CAM nach Anspruch 1, der weiterhin ein Blind-Wort zur Feststellung umfasst, wann eine ausreichende Zeit abgelaufen ist, damit eine Übereinstimmung abgeschlossen ist, wobei
das Wort in die gleiche Anzahl von Kettensegmenten wie ein tatsächliches Speicherwort segmentiert ist;
jedes Kettensegment die gleiche Anzahl von Zellen wie ein tatsächliches Speicher-Kettensegment hat, jedoch aus Blind-Kernzellen anstatt aus tatsächlichen Kernzellen besteht;
jedes Kettensegment immer leitet, um eine Übereinstimmung zu modellieren, und auf Vergleichs-Bitleitungs-Übergänge in der gleichen Weise wie ein tatsächliches Kettensegment mit einer Übereinstimmung anspricht.

33. CAM nach Anspruch 1, der weiterhin einen globalen Datenbus umfasst, der periphere Schaltungen mit Worten des CAM verbindet, wobei der Bus alle Worte verbindet und für Such-Lese- oder Schreiboperationen verwendet wird und bidirektionale Daten liefert, und wobei alle Treiber auf dem Bus in einen Tristate zu versetzen sind.

## Revendications

1. Mémoire associative, appelée ci-après CAM, comprenant :
w mots de moyens de correspondance, chaque mot comprenant b cellules centrales agencées en i segments de chaîne de ligne de correspondance, chaque segment de chaîne de ligne de correspondance comprenant b/i cellules centrales (210), chaque cellule centrale (210) comprenant des moyens pour stocker des données, w, i, b et b/i étant des entiers, i et b/i étant supérieurs ou égaux à deux ;
des moyens logiques ET et NONET (218, 220) pour coupler logiquement les segments de chaîne de ligne de correspondance dans un mot respectif ; et
des moyens de codage (218) pour générer des résultats de recherche sur la base des sorties des moyens logiques,
**caractérisée en ce que** :
les cellules centrales de chaque segment de chaîne de ligne de correspondance sont chaînées en série par une ligne de correspondance (212) ; et
l'ordre des bits dans un mot est brouillé de manière déterministe entre les différents segments de chaîne de ligne de correspondance constituant chaque mot.

2. CAM selon la revendication 1, dans laquelle les moyens logiques (218, 220) comprennent des moyens de circuit NONET qui génèrent des sorties logiques en réponse aux sorties des segments de chaîne de ligne de correspondance dans une rangée respective.

3. CAM selon la revendication 1, comprenant en outre des moyens pour détecter les transitions de signaux de données sur les chaînes.

4. CAM selon la revendication 3, dans laquelle la polarité du signal de données bascule pour indiquer qu'une correspondance est haute ou basse.

5. CAM selon la revendication 1, dans laquelle i = 2 et une paire de segments de chaîne de ligne de correspondance sont orientés en images dans un miroir, de sorte que leurs sorties se fassent mutuellement face, de manière à faciliter la combinaison logique des deux résultats de correspondance partiels des deux segments de chaîne, par des moyens logiques (218, 220).

6. CAM selon la revendication 5, dans laquelle les moyens logiques (218, 220) comprennent des moyens logique ET (220) et les lignes de correspondance de mot (224), résultant de la logique ET appliquée aux résultats de correspondance partiels sur les segments de chaîne de ligne de correspondance, une ligne de correspondance de mot (224) par mot, sont acheminées de manière à transmettre le résultat de correspondance aux moyens de codage (222).

7. CAM selon la revendication 6, dans laquelle les lignes de correspondance de mot (224) sont sélectivement acheminées physiquement sur les cellules centrales (210) dans une couche métallique au-dessus de tous les autres signaux utilisés dans la cellule centrale (210).

8. CAM selon la revendication 6, dans laquelle les moyens de codage (222) comprennent une pluralité de codeurs.

9. CAM selon la revendication 6, dans laquelle des mots multiples sont placés en position adjacente aux moyens de codage (222), des lignes de correspondance de mot multiples (224) s'étendant sur chaque cellule centrale, ce qui permet que des lignes de correspondance de mot multiples (224) soient acheminées par rangée.

10. CAM selon la revendication 9, dans laquelle les lignes de correspondance de mot (224) sont sélectivement acheminées sur les cellules centrales (210) dans une couche métallique au-dessus de tous les autres signaux utilisés dans la cellule centrale (210).

11. CAM selon la revendication 6, dans laquelle les résultats de correspondance partiels sont sélectivement acheminés au-dessus de la cellule centrale (210), pour être combinés dans les moyens logiques ET (220).

12. CAM selon la revendication 11, dans laquelle les résultats de paires de segments de chaîne de ligne de correspondance (212) sont dans un premier temps combinés par une opération ET logique en un résultat partiel secondaire, le résultat étant ensuite acheminé au-dessus de la cellule centrale (210), pour être combiné dans une porte ET finale adjacente au codeur (222).

13. CAM selon la revendication 1, dans laquelle la cellule centrale (210) comprend une pluralité de transistors à effet de champ, appelés ci-après FET, pour des opérations de stockage de données, et comprenant en outre des moyens de niveau logique/précharge pour fournir un premier niveau logique binaire à une extrémité des segments de chaîne et pour précharger le segment de chaîne de ligne de correspondance dans le deuxième niveau logique binaire en réponse à un signal d'horloge.

14. CAM selon la revendication 13, dans laquelle les moyens de niveau logique/précharge comprennent des moyens pour lier l'extrémité du segment de chaîne directement à une alimentation électrique du premier niveau logique binaire.

15. CAM selon la revendication 13, dans laquelle les moyens de niveau logique/précharge comprennent un premier FET à l'autre extrémité de la chaîne la plus proche du circuit de détection de correspondance.

16. CAM selon la revendication 15, dans laquelle les moyens de niveau logique/précharge comprennent des moyens pour précharger le segment de chaîne dans le deuxième niveau logique binaire, en commençant après le début du cycle d'horloge durant lequel la recherche doit être effectuée, par le premier FET.

17. CAM selon la revendication 15, dans laquelle les moyens de niveau logique/précharge comprennent en outre des moyens pour précharger le segment de chaîne dans le deuxième niveau logique binaire, en commençant après la fin de l'opération de recherche, en continuant durant l'état au repos sans recherche de la CAM, et en cessant avant le début de l'opération de recherche suivante, par le premier FET, les FET des segments de chaîne étant dans un état conducteur durant la précharge, en raison du niveau logique haut sur leurs portes.

18. CAM selon la revendication 13, dans laquelle les moyens de niveau logique/précharge comprennent le premier FET à une extrémité du segment de chaîne et un deuxième FET à l'autre extrémité du segment de chaîne la plus éloignée du circuit de détection de correspondance.

19. CAM selon la revendication 18, dans laquelle les moyens de niveau logique/précharge comprennent des moyens pour connecter une extrémité de la chaîne à une alimentation électrique du premier niveau logique binaire, par un troisième FET qui devient conducteur lorsque les premier et deuxième FET sont non conducteurs, les FET de la chaîne étant dans un étant conducteur durant la précharge, en raison du niveau logique haut sur leurs portes.

20. CAM selon la revendication 18, dans laquelle le deuxième FET est conducteur lorsque le premier FET est non conducteur.

21. CAM selon la revendication 13, dans laquelle,
les moyens de niveau logique/précharge comprennent des moyens de niveau logique et des moyens de précharge,
les moyens de précharge comprenant des moyens pour précharger le segment de chaîne dans le deuxième niveau logique binaire, en commençant après la fin de l'opération de recherche, en continuant durant l'état au repos sans recherche de la CAM, et en cessant avant le début de l'opération de recherche suivante, par un premier FET à l'extrémité du segment de chaîne le plus proche du circuit de détection de correspondance ;
les moyens de niveau logique étant destinés à lier directement l'extrémité du segment de chaîne à une alimentation électrique du premier niveau logique binaire ; et
la cellule centrale dans la chaîne à l'extrémité vers le circuit de détection de correspondance comprenant des FET identiques à ceux des autres cellules centrales dans le segment de chaîne, les données de comparaison étant appliquées à la polarité opposée durant l'état de précharge au repos, de sorte que le FET du segment de chaîne soit le seul FET dans la chaîne qui sont non conducteur dans l'état de précharge au repos.

22. CAM selon la revendication 13, dans laquelle,
les moyens de niveau logique/précharge comprennent des moyens de niveau logique et des moyens de précharge,
les moyens de précharge étant destinés à précharger la chaîne dans le deuxième niveau logique binaire, en commençant après la fin de l'opération de recherche, en continuant durant l'état au repos sans recherche de la CAM, et en cessant avant le début de l'opération de recherche suivante, par un premier FET à l'extrémité du segment de chaîne le plus proche du circuit de détection de correspondance,
les moyens de niveau logique étant destinés à lier directement le segment de chaîne à une alimentation électrique du premier niveau logique binaire,
la cellule centrale à un emplacement prédéterminé et constant dans le segment de chaîne comprenant des FET identiques à ceux des autres cellules centrales dans la chaîne, les données de comparaison étant appliquées à la polarité opposée durant l'état de précharge au repos, de sorte que le FET de segment de chaîne soit le seul FET dans le segment de chaîne qui soit non conducteur dans l'état de précharge au repos, de manière à ce qu'un partage de charge quelconque se produisant durant la recherche du segment de chaîne ait tendance à ce qu'une non-correspondance ressemble quelque peu à une correspondance, mais avec un degré de partage de charge connu et pris en compte.

23. CAM selon la revendication 13, dans laquelle la cellule centrale (210) comprend :
des premier et deuxième FET de canal N et des premier et deuxième FET de canal P formant deux inverseurs à couplage croisé pour stocker des données différentielles ;
des troisième et quatrième FET de canal N (710, 712) couplés aux noeuds de données différentielles à des lignes binaires différentielles, les FET étant déclenchés par une ligne de mot, de manière à permettre d'accéder pour des opérations de lecture et écriture de données ;
un cinquième FET de canal N (723) ;
des sixième et septième FET de canal N (721, 725), l'un quelconque étant déclenché par le noeud de stockage positif et pour connecter une ligne de bit de comparaison positive à la porte du cinquième FET de canal N (723), l'autre étant déclenché par le noeud de stockage négatif et pour connecter une ligne de bit de comparaison négative à la porte du cinquième FET de canal N (723), les lignes de bit de comparaison étant physiquement distinctes des lignes de bit utilisées pour l'accès en lecture et en écriture, la source et le drain du cinquième FET de canal N (723) étant connectés à ceux des cellules voisines pour former un segment de chaîne de tels FET.

24. CAM selon la revendication 1, comprenant en outre un segment de chaîne de ligne de correspondance factice comprenant un réseau de cellules CAM de stockage de données couplées à des lignes de bit.

25. CAM selon la revendication 24, dans laquelle chaque cellule CAM du segment de chaîne de ligne de correspondance factice est une cellule CAM modèle, qui a une correspondance garantie et a un FET de chaîne conducteur, la cellule CAM modèle comprenant :
une combinaison de deux FET de canal N et deux FET de canal P formant deux inverseurs à couplage croisé, mettant en oeuvre un stockage de données différentielles statiques ;
deux FET de canal N supplémentaires, connectant les noeuds de données différentielles statiques à des lignes de bit différentielles, déclenchés par une ligne de mot, afin de permettre l'accès pour des opérations de lecture et d'écrituie ;
deux FET de canal N supplémentaires, l'un étant déclenché par une ligne de bit de comparaison positive, et connectant une ligne de bit de comparaison positive à la porte d'un troisième FET de canal N supplémentaire ; l'autre étant déclenché par une ligne de bit de comparaison négative, et connectant une ligne de bit de comparaison négative à la porte du même troisième FET de canal N supplémentaire ;
les lignes de bit de comparaison étant physiquement distinctes des lignes de bit utilisées pour l'accès en lecture et en écriture ;
un troisième FET de canal N, sa porte étant connectée comme décrit ci-dessus, avec une source et un drain connectés à des transistors similaires dans les cellules voisines pour former une chaîne de tels composants.

26. CAM selon la revendication 24, dans laquelle chaque cellule CAM de la chaîne de ligne de comparaison factice est une cellule CAM modèle, dont la correspondance est garantie lorsqu'une des lignes de bit de comparaison est dans un état logique haut, et son FET de segment de chaîne est conducteur dans ce cas, la cellule CAM modèle comprenant :
deux FET de canal N facultatifs, avec un drain et une source non connectés, déclenchés par une ligne de mot, dans le but d'effectuer un chargement de modèle vers la ligne de mot ;
une combinaison d'un FET de canal N et d'un FET de canal P formant un inverseur, inversant l'état logique d'une ligne de bit de comparaison positive ;
une combinaison d'un FET de canal N et d'un FET de canal P formant un inverseur, inversant l'état logique d'une ligne de bit de comparaison négative ;
deux FET de canal N supplémentaires, l'un étant déclenché par la ligne de bit de comparaison positive inversée, et connectant la ligne de bit de comparaison négative à la porte d'un troisième FET de canal N supplémentaire, l'autre étant déclenché par la ligne de bit de comparaison négative inversée, et connectant la ligne de bit de comparaison positive à la porte du même troisième FET de canal N supplémentaire ;
un troisième FET de canal N supplémentaire, sa porte étant connectée comme décrit ci-dessus, avec une source et un drain connectés à des transistors similaires dans les cellules voisines (ou aux autres circuits appropriés dans les cas limitrophes) pour former une chaîne de tels composants.

27. CAM selon la revendication 24, dans laquelle chaque cellule CAM du segment de chaîne de ligne de correspondance factice est une cellule CAM modèle, qui a une correspondance garantie et a un FET de segment de chaîne conducteur, la cellule modèle comprenant :
une paire de lignes de bit différentielles, sélectivement incluses, mais non électriquement connectées au reste de la cellule centrale ;
une ligne de bit de comparaison négative, sélectivement incluse, mais non électriquement connectée au reste de la cellule centrale ;
deux FET de canal N, connectant les noeuds de stockage différentiel statiques à : la tension d'alimentation positive, dans le cas du noeud de stockage statique négatif, et une source flottante, dans le cas du noeud de stockage statique positif, déclenchés par une ligne de mot ;
un premier FET de canal P, dont la source est connectée à la tension d'alimentation positive, et sa porte et son drain sont connectés conjointement au noeud de stockage statique négatif, qui est maintenu dans un état logique haut par l'agencement ;
un troisième FET de canal N, dont la source est connectée à la tension d'alimentation négative, sa porte étant connectée au noeud de stockage statique négatif, ledit noeud étant amené à un niveau haut par le premier FET de canal P, résultant en sa conduction de sorte que son drain, connecté au noeud de stockage statique positif, soit maintenu dans un état logique bas par l'agencement ;
un deuxième FET de canal P, dont la source est connectée à la tension d'alimentation positive, sa porte étant connectée au noeud de stockage statique positif, ledit noeud étant maintenu dans un état logique bas par le troisième FET de canal N comme décrit ci-dessus, résultant en sa conduction de sorte que son drain, connecté au noeud de stockage statique négatif, soit renforcé dans son état logique haut imposé par le premier FET de canal P, conducteur ;
un quatrième FET de canal N, dont la source est connectée à la tension d'alimentation négative, sa porte étant connectée au noeud de stockage statique positif, résultant en ce qu'il soit dans un état non conducteur, et son drain n'est électriquement connecté à aucun autre noeud quelconque ;
deux FET de canal N supplémentaires : le premier étant déclenché par le noeud de stockage statique positif, et connectant une ligne de bit de comparaison positive à la porte d'un troisième FET de canal N supplémentaire, ledit dispositif étant dans un état non conducteur en raison de l'état logique bas de sa porte ; le second étant déclenché par le noeud de stockage statique négatif, et connectant la tension d'alimentation positive à la porte du même troisième FET de canal N supplémentaire, ledit dispositif étant dans un état conducteur en raison de l'état logique haut de sa porte ;
une ligne ou des lignes de comparaison quelconques présentes étant physiquement distinctes de la ligne ou des lignes présentes quelconques utilisées pour l'accès en lecture et en écriture ;
un troisième FET de canal N supplémentaire, dont la porte est connectée comme décrit ci-dessus et dans un état haut, le FET étant dans un état conducteur, la source et le drain étant connectés à des transistors similaires dans des cellules voisines pour former une chaîne de tels dispositifs.

28. CAM selon la revendication 27, dans laquelle, dans chaque cellule CAM modèle, l'un ou les deux parmi (i) la connexion de tension d'alimentation positive au transistor déclenché par la ligne de mot et également connecté au noeud de stockage statique négatif, et (ii) la connexion de ligne de bit de comparaison au premier FET de canal N supplémentaire, peuvent être remplacées par un noeud flottant ou non connecté.

29. CAM selon la revendication 27, dans laquelle, dans chaque cellule CAM modèle, tous les noeuds différentiels sont remplacés par leurs polarités complémentaires correspondantes de positive et négative en négative et positive, respectivement.

30. CAM selon la revendication 28, dans laquelle, dans chaque cellule CAM modèle, tous les noeuds différentiels sont remplacés par leurs polarités complémentaires correspondantes de positive et négative en négative et positive, respectivement.

31. CAM selon la revendication 1, comprenant en outre un segment de chaîne factice pour déterminer à quel moment la précharge de toutes les chaînes est terminée, les segments de chaîne factices comprenant autant de cellules factices que les cellules centrales d'un segment de chaîne de stockage réel, le segment de chaîne factice étant toujours conducteur pour modéliser une correspondance, répondant aux transitions de ligne de bit de comparaison de la même manière qu'un segment de chaîne réel avec une correspondance, le segment de chaîne factice comprenant des moyens pour détecter à quel moment une précharge est terminée, à son extrémité opposée au circuit de precharge.

32. CAM selon la revendication 1, comprenant en outre un mot factice pour déterminer à quel moment un temps suffisant s'est écoulé pour qu'une correspondance soit terminée, dans laquelle
le mot est segmenté en le même nombre de segments de chaîne qu'un mot de stockage réel ;
chaque segment de chaîne a le même nombre de cellules qu'un segment de chaîne de stockage réel, mais est composé de cellules centrales factices, à la place de cellules centrales réelles ;
chaque segment de chaîne est toujours conducteur pour modéliser une correspondance, et répond aux transitions de ligne de bit de comparaison de la même manière qu'un segment de chaîne réel avec une correspondance.

33. CAM, selon la revendication 1, comprenant en outre un bus de données global, connectant les circuits périphériques aux mots de la CAM, dans laquelle le bus unit tous les mots et est utilisé pour des opérations de recherche, de lecture ou d'écriture, en fournissant des données de manière bidirectionnelle, et tous les pilotes sur le bus peuvent être à trois états.
